Europäisches Patentamt

European Patent Office

Office européen des brevets

(11) Veröffentlichungsnummer: **0 370 412**

**A1**

(12) **EUROPÄISCHE PATENTANMELDUNG**

(21) Anmeldenummer: **89121366.2**

(22) Anmeldetag: **18.11.89**

(51) Int. Cl.⁵: **H01L 25/07**

Die Bezeichnung der Erfindung wurde geändert (Richtlinien für die Prüfung im EPA, A-III, 7.3).

(30) Priorität: **22.11.88 DE 3839383**

(43) Veröffentlichungstag der Anmeldung:
**30.05.90 Patentblatt 90/22**

(84) Benannte Vertragsstaaten:
**CH DE FR GB IT LI SE**

(71) Anmelder: **SEMIKRON ELEKTRONIK GMBH**
**Sigmundstrasse 200 Postfach 82 02 51**
**D-8500 Nürnberg 82(DE)**

(72) Erfinder: **Schierz, Winfried**
**Heideweg 2**
**D-8548 Heideck(DE)**

(54) **Vereinfachter Zusammenbau eines Halbleiterelements.**

(57) Bei bekannten Halbleiterbaueinheiten in Kompaktbauweise mit elektrisch isoliert und thermisch leitend befestigten Halbleiterelementen erfordert das Anordnen mehrerer Stromleitungselemente sowie das Justieren aller Bauteile beim Zusammenbau einen für eine rationelle Großserienfertigung nachteiligen Verfahrensaufwand. Mit dem Verfahren und der Vorrichtung nach der Erfindung wird der Zusammenbau von Halbleiterelementen und deren Stromleiterelementen vereinfacht.

Gemäß dem Verfahren wird die Vorrichtung als Leiterteilstruktur, die als erste und als zweite Kontaktelemente (1, 2) bzw. als Anschlußelemente ausgebildete Abschnitte aufweist, mit den ersten Kontaktelementen auf eine Trägerplatte (15) aufgebracht. Jeweils zwischen erstes und zweites Kontaktelement wird ein Halbleiterelement eingefügt. Nach dem Verbinden durch Löten wird der Transportsteg (7) zwischen den Anschlußelementen (4, 5) entfernt.

Fig. 2

## Verfahren zum Herstellen einer Halbleiterbaueinheit und Vorrichtung zur Durchführung des Verfahrens.

Die Erfindung betrifft ein Verfahren zum Herstellen einer Halbleiterbaueinheit mit den Merkmalen nach dem Oberbegriff des Anspruchs 1 sowie eine Vorrichtung zur Durchführung des Verfahrens mit den Merkmalen nach dem Oberbegriff des Anspruchs 7.

Aus dem DE-GM 75 12 573 und aus der DE-PS 26 39 979 sind als Module bezeichnete Halbleiterbaueinheiten in Kompaktbauweise bekannt, bei welchen jeweils z.B. zwei scheibenförmige Halbleiterelemente elektrisch isoliert auf einer gemeinsamen, thermisch leitenden Unterlage befestigt und elektrisch geschaltet sind. Je ein dem Eingang und dem Ausgang der Schaltung zugeordnetes sowie das dem Verbindungsleiter zwischen den Halbleiterelementen zugehörige Stromanschlußelement sind in Reihe und in bestimmter Folge angebracht. Die beiden äußeren der aufgereihten Anschlußelemente sind jeweils zusammen mit den zugehörigen Halbleiterelementen auf einem Kontaktelement befestigt und mit diesem über eine Isolierstoff-Zwischenschicht auf einer gemeinsamen metallischen Grundplatte aufgebracht. Die Anschlußelemente erstrecken sich sämtlich nach der von der Zwischenschicht abgewandten Seite der Halbleiterelemente und ermöglichen damit eine einfache Kontaktierung der Baueinheit nur auf einer Seite.

Entsprechend diesem Aufbau sind auch Halbleiterbaueinheiten mit einem Halbleiterelement bekannt.

Beim Herstellen dieser bekannten Bauformen erfordert das Anordnen mehrerer Kontakt- und Anschlußelemente sowie das Justieren und Haltern allerBauteile beim Zusammenbau mit Halbleiterelementen einen für eine rationelle Großserienfertigung von Halbleitermodulen mit einem oder mehreren Halbleiterelementen nachteiligen Verfahrensaufwand.

Der Erfindung liegt die Aufgabe zugrunde, den Zusammenbau von Halbleiterelementen und zugehörigen Bauteilen beim Herstellen solcher Baueinheiten zu vereinfachen.

Die Lösung der Aufgabe besteht bei dem eingangs genannten Verfahren in den kennzeichnenden Merkmalen des Anspruchs 1 und bei der verwendeten Vorrichtung in der Ausgestaltung nach den Merkmalen des Anspruchs 7. Weiterbildungen des Gegenstandes der Erfindung sind in den Unteransprüchen angegeben.

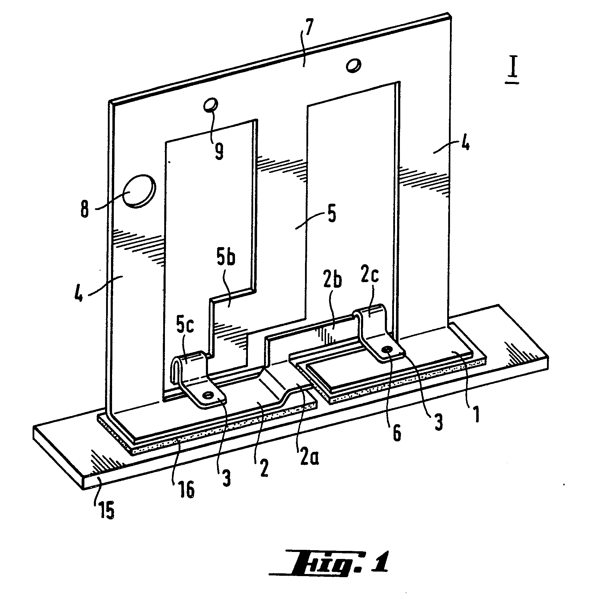

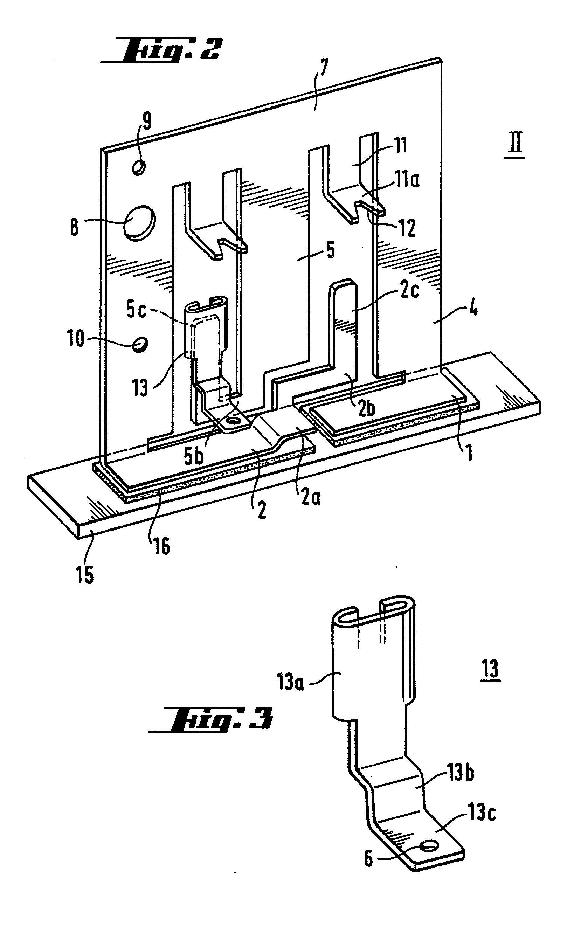

Anhand der in den Figuren 1 bis 3 dargestellten Ausführungsbeispiele für Halbleiterbaueinheiten mit zwei Halbleiterelementen wird die Erfindung erläutert. Die Figuren 1 und 2 zeigen perspektivisch je eine Vorrichtung und in Figur 3 ist ebenfalls perspektivisch ein Kontaktelement für die Vorrichtung nach Figur 2 dargestellt. Aus den Figuren 1 und 2 ist die Ausführungsform einer Baueinheit mit einem Halbleiterelement durch entsprechende Beschränkung erkennbar. Gleiche Teile sind in allen Figuren mit gleichen Bezeichnungen versehen.

Der Vorrichtung (I) gemäß Figur 1 liegt eine durch Stanzen erzielte sogenannte Platine aus bandförmigem Leitermaterial mit einem Leiterteilmuster zugrunde, welches sämtliche Kontakt- und Anschlußelemente der vorgesehenen Halbleiterbaueinheit in einer Grundebene aufweist. Erfindungsgemäß sind erste Abschnitte durch Biegen aus der Grundebene in eine erste Ebene als erste Kontaktelemente (1, 2) angeordnet und zur Auflage jeweils eines nicht dargestellten, scheibenförmigen Halbleiterelements vorgesehen. Die an die ersten Kontaktelemente (1, 2) anschließenden und als Leiterteile für dieselben dienenden, in der Grundebene verlaufenden, stegförmigen Abschnitte bilden Anschlußelemente (4, 5) in der zur ersten Ebene in einem Winkel liegenden, nunmehr als zweite Ebene bezeichneten Grundebene. Sie erstrecken sich gegenseitig parallel über eine durch die Bemessung des gehäuseinneren Aufbaus der Halbleiterbaueinheit und durch die zum gehäuseäußeren Stromanschluß erforderliche Ausdehnung bestimmte Länge und sind über einen querliegenden Transportsteg (7) verbunden. Das teilweise dem einen ersten Kontaktelement (2) benachbarte Anschlußelement (5) weist einen zu diesem in der zweiten Ebene gegenläufigen Fortsatz (5c) auf, dessen Ende als eines der zweiten Kontaktelemente (3) vorgesehen, aus der zweiten Ebene ausgerückt und zur Auflage auf einem Halbleiterelement in einer dritten Ebene parallel über der ersten Ebene angeordnet ist. Weiter ist das eine erste Kontaktelement (2) mit einer an der inneren Kante des Endabschnitts (2a) anschließenden, bandförmigen Kontaktfahne (2b) versehen. Diese verläuft neben dem anderen ersten Kontaktelement (1) und ist am Ende (2c) als anderes der zweiten Kontaktelemente (3) vorgesehen und in entsprechender Weise aus der zweiten Ebene herausgerückt und in der dritten Ebene über der ersten Ebene angeordnet. Zur erforderlichen räumlichen Zuordnung der Kontaktelemente und des Halbleiterelements ist der Endabschnitt (2a) des einen ersten Kontaktelements (2) gekröpft angebracht.

Das den Fortsatz (5c) aufweisende Anschlußelement (5) ist zweites Anschlußelement in einer Baueinheit mit einem Halbleiterelement und mittleres Anschlußelement gemäß den Figuren 1 und 2 in einer Baueinheit mit zwei Halbleiterelementen, und das oder die Anschlußelemente (4) ist bzw. sind jeweils erste Anschlußelemente.

Diese Vorrichtung (I) wird nun mit der planen Unterseite der ersten Kontaktelemente (1, 2) auf die elektrisch isolierende Zwischenschicht (16), die auf der metallischen Grundplatte (15) befestigt ist und mit dieser eine Trägerplatte bildet, aufgesetzt. Die Auflagefläche kann mit einem benetzungsfördernden Überzug versehen werden. Vorzugsweise wird eine Zwischenschicht aus Keramik verwendet, z.B. aus Aluminiumoxid oder Aluminiumnitrid. Die Zwischenschicht kann mehrfach unterteilt sein, und sie ist zur Erzielung bestmöglicher Ableitung der Verlustwärme beim Einsatz der Anordnung so dünn wie verfahrenstechnisch möglich ausgebildet.

Mit einer Zwischenschicht (16) aus einer Keramik mit aufgebondeter Metallisierung wurden günstige Ergebnisse erzielt.

Nach dem Aufsetzen derselben wird jeweils zwischen die ersten Kontaktelemente (1, 2) und die räumlich diesen entsprechend zugeordneten, zweiten Kontaktelemente (3) je ein nicht dargestelltes Halbleiterelement eingefügt. Dazu sind die zweiten Kontaktelemente (3) in solchem Abstand zu den ersten vorgesehen, daß jedes zusammen mit dem jeweiligen ersten Kontaktelement eine klammerförmige Halterung für ein Halbleiterelement bildet und dieses durch minimales Aufbiegen des zweiten Kontaktelements zwischengefügt werden kann.

Die vor den zweiten Kontaktelementen (3) befindlichen Leiterteilabschnitte, Teile der Endabschnitte (2c und 5c), weisen je einen Dehnungsbogen zum Ausgleich thermisch bedingter, mechanischer Spannungen auf.

Nach dem Einlegen der Halbleiterelemente werden in einem Lötprozeß die jeweils aneinandergrenzenden Bauteile an sämtlichen vorzugsweise vorbehandelten Verbindungsflächen gegenseitig fest verbunden. Demzufolge wird in überraschend einfacher Weise mit Hilfe der Vorrichtung (I) in zwei Bestückschritten und einem Lötschritt mit einem Minimum an Arbeits- und Verfahrensaufwand eine ungekapselte Halbleiterbaueinheit als Zwischenprodukt erzielt. Schließlich wird der die Anschlußelemente (4, 5) verbindende Transportsteg (7) entfernt. Die nun vorliegende Anordnung wird in einem Isolierstoffgehäuse untergebracht und für die gehäuseäußere Verbindung mit Stromleiterelementen vorbereitet.

Als Trägerplatte kann auch lediglich eine Keramikplatte mit aufgebondeter Metallisierung verwendet werden.

In Figur 1 ist eine einstückige Vorrichtung (I) dargestellt, bei welcher jeweils erstes und zweites Kontaktelement Abschnitte der Vorrichtung und gegenseitig fest zugeordnet sind.

Die Vorrichtung (1) kann auch als mehrstückige Bauform (II) ausgebildet sein, wie dies in Figur 2 gezeigt ist. Sie unterscheidet sich von der einstückigen Vorrichtung (I) nach Figur 1 im wesentlichen dadurch, daß die nach Figur 1 als zweite Kontaktelemente (3) ausgebildeten Abschnitte (2c, 5c) in ihrer ursprünglichen Form in der Ebene des Leiterteilmusters verbleiben. In dieser bilden sie stegförmige Enden (2c) der bandförmigen Kontaktfahne (2b) bzw.(5c) des mittleren Anschlußelements (5). Auf diese Enden (2c, 5c) werden besonders gefertigte Kontaktbauteile (13) aufgesteckt, wie sie in Figur 3 dargestellt sind. Diese bestehen aus einem hülsenförmigen Schenkel (13a), einem dazu rechtwinklig angeordneten, plattenförmigen, als zweites Kontaktelement vorgesehenen Schenkel (13c) und einem stufenförmigen Verbindungsstück (13b), mit welchem die erforderliche geometrische Position des zweiten Kontaktelements (13c) über dem ersten Kontaktelement (1, 2) zur Auflage auf dem Halbleiterelement erzielt wird. Weiter sichert der hülsenförmige Schenkel (13a), über das jeweilige Ende (2c bzw. 5c) geführt, die justierte räumliche Zuordnung des beweglich gehalterten, lose auf dem Halbleiterelement aufliegenden, zweiten Kontaktelements (13c). Die Lötverbindung von Halbleiterelement und Kontaktelementen (2, 13c) kann bei dieser Bauform z.B. mit Hilfe eines entsprechenden Gewichts auf dem Kontaktelement (13c) erzielt werden.

Zusätzlich sind zwischen den Anschlußelementen (4, 5) der Vorrichtung (II) vom Transportsteg (7) ausgehende Ausbildungen zur Anordnung und Halterung von zusätzlichen Bauteilen oder Leiterteilen, z.B. Hilfselektroden der Halbleiterelemente, vorgesehen und parallel zur und im Abstand über der ersten Ebene angeordnet, mit welchem jedoch auch die einstückige Vorrichtung (I) ausgerüstet werden kann. Der senkrecht vorstehende Abschnitt (11a) der Ausbildungen (11) weist eine in der Längsachse von der Vorderkante aus verlaufende Kerbe (12) auf. In dieser wird z.B. ein zusätzlicher drahtförmiger Anschluß des unterhalb der Kerbe (12) liegenden Halbleiterelements geführt, der in dem in der Durchbohrung (6) des zweiten Kontaktelements (3, 13c) freiliegenden Oberflächenteil des Halbleiterelements befestigt ist und sich durch die Durchbohrung zum Abschnitt (11a) der Ausbildung (11) erstreckt.

Die Vorrichtungen (I, II) sind demzufolge auch als Lötvorrichtungen zum Haltern und Justieren von zusätzlichen Bauteilen verwendbar.

Jede Vorrichtung weist in dem zur Ausbildung eines gehäuseäußeren Stromanschlusses vorgesehenen Bereich der Anschlußelemente (4, 5), in den Figuren für eines derselben gezeigt, eine Durchbohrung (8) auf, welche vorzugsweise mit einer im Deckelteil des Gehäuses vorgesehenen Einpreßmutter übereinstimmend, zur Befestigung eines Stromleiterelements dient.

Weiter ist jede Vorrichtung (I, II) im Verlauf des Transportsteges (7) mit Öffnungen (9) zur mechanisierten Bearbeitung versehen. Dadurch können auf einem entsprechenden Transportband aufgereihte Vorrichtungen z.B. auch im Arbeitstakt vor ihrem Aufbringen auf die Trägerplatte mit Halbleiterelementen bestückt und anschließend in einem Durchlaufofen mit den Halbleiterelementen durch Löten fest verbunden werden. Weiter können die Verfahrensschritte "Aufbringen auf Trägerplatte","Bestücken mit Halbleiterelementen" und "Löten" auch mechanisiert am Transportband erfolgen.

Die Vorrichtungen (I, II) können weiter im gehäuseinneren Bereich ihrer Anschlußelemente (4, 5) zur mechanisch festen Verankerung des Aufbaus in einer Isolierstoff-Gießmasse noch Öffnungen (10) aufweisen.

**Ansprüche**

1. Verfahren zum Herstellen einer Halbleiterbaueinheit, bei dem
- auf einer Trägerplatte (15, 16) zur elektrisch isolierten, thermisch leitenden Befestigung von wenigstens einem Halbleiterelement
- ein erstes Kontaktelement (2) zur trägerplattenseitigen Kontaktierung des Halbleiterelements,
- auf dem ersten Kontaktelement (2) das Halbleiterelement und
- weiter ein zweites Kontaktelement (3, 13c) zur oberseitigen Kontaktierung des Halbleiterelements angeordnet werden,
- das Halbleiterelement mit allen beidseitig anschließenden Bauteilen in einem Verfahrensschritt fest verbunden und
- in einem Isolierstoffgehäuse untergebracht wird, sowie
- Anschlußelemente (4, 5) verwendet werden, welche auch für eine gehäuseäußere Verbindung mit Stromleiterelementen ausgebildet sind,
**dadurch gekennzeichnet, daß**
- auf die Trägerplatte (15, 16) eine Vorrichtung (I, II) aus bandförmigem Leitermaterial aufgebracht wird, welche jeweils als erstes Kontaktelement (2), als zweites Kontaktelement (3, 13c) bzw. als Anschlußelement (4, 5) ausgebildete Bauteile in jeweils entsprechender, gegenseitiger räumlicher Zuordnung aufweist,
- das Halbleiterelement zwischen erstem und zweitem Kontaktelement (2; 3, 13c) der Vorrichtung (I, II) angeordnet wird, und
- nach dem Herstellen der festen Verbindung zwischen Halbleiterelement und seinen Kontaktelementen (2; 3, 13c) der die Anschlußelemente (4, 5) verbindende Transportsteg (7) entfernt wird.

2. Verfahren nach Anspruch 1, dadurch gekennzeichnet, daß eine einstückige Vorrichtung (I) aufgebracht wird, bei welcher erstes (2) und zweites Kontaktelement (3) Abschnitte der Vorrichtung (I) und gegenseitig fest zugeordnet sind.

3. Verfahren nach Anspruch 1, dadurch gekennzeichnet, daß eine mehrstückige Vorrichtung (II) aufgebracht wird, bei welcher das zweite Kontaktelement (13) als getrenntes Teil für loses Aufsetzen auf das Halbleiterelement an der Vorrichtung (II) beweglich gehalten angeordnet ist.

4. Verfahren nach Anspruch 1, dadurch gekennzeichnet, daß das Halbleiterelement mit den zugeordneten Bauteilen durch Löten fest verbunden wird.

5. Verfahren nach Anspruch 1, dadurch gekennzeichnet, daß die Vorrichtung (II) gleichzeitig als Lötvorrichtung mit Ausbildungen (11) zur Anordnung und Halterung von zusätzlichen Bauteilen verwendet wird.

6. Verfahren nach Anspruch 1, dadurch gekennzeichnet, daß eine Trägerplatte verwendet wird, die aus einer metallischen Grundplatte (15) und einer auf dieser befestigten, elektrisch isolierenden, thermisch gut leitenden Zwischenschicht (16) besteht.

7. Vorrichtung zur Durchführung des Verfahrens nach den Ansprüchen 1 bis 6, bestehend aus
- wenigstens einem, ein erstes Kontaktelement (2) bildenden Abschnitt zur Auflage eines Halbleiterelements,
- einem vom ersten Kontaktelement (2) aus sich erstreckenden, stegförmigen und als erstes Anschlußelement (4) vorgesehenen weiteren Abschnitt, und
- einem neben dem Anschlußelement (4) verlaufenden, mit diesem durch einen Transportsteg (7) verbundenen, weiteren Anschlußelement (5), das mit einem, dem ersten Kontaktelement (2) benachbarten Fortsatz (5c) endet,
**dadurch gekennzeichnet, daß**
- das erste Kontaktelement (2) in einer ersten Ebene und
- die Anschlußelemente (4, 5) nebeneinander in einer zweiten Ebene in einem Winkel zur ersten Ebene angeordnet sind, sowie
- der Fortsatz (5c) des weiteren Anschlußelements (5) mit einem daran befestigten, zweiten Kontaktelement (3) versehen ist, das in einer dritten Ebene parallel über der ersten Ebene angebracht ist.

8. Vorrichtung nach Anspruch 7 zum Anordnen und Schalten von zwei Halbleiterelementen, dadurch gekennzeichnet, daß sie aus zwei ersten Kontaktelementen (1, 2) in Reihe in der ersten Ebene, zwei ersten, in der zweiten Ebene und senkrecht zur ersten Ebene verlaufenden Anschlußelementen (4), jeweils mit einem ersten Kontaktelement (1, 2) verbunden, sowie einem zwischen beiden ersten Anschlußelementen (4) in gleicher Ebene liegenden, weiteren Anschlußelement (5) mit einem ein zweites Kontaktelement (3) aufweisenden Fortsatz (5c) und einer bandförmigen Kontaktfahne (2b) als Verlängerung des einen ersten Kontaktelements (2), die als Verbindungselement (2a - 2b) zur elektrischen Schaltung der Halbleiterelemente vorgesehen ist, mit einem daran befestigten, weiteren zweiten Kontaktelement (13c), das zusammen mit dem zweiten Kontaktelement (3) des Fortsatzes (5c) in der dritten über der ersten Ebene angebracht ist, besteht.

9. Vorrichtung nach Anspruch 8, dadurch gekennzeichnet, daß der Fortsatz (5c) und das Ende (2c) der Kontaktfahne (2a - 2b) jeweils als zweites Kontaktelement (3) ausgebildet, aus der jeweiligen Teileebene ausgerückt und zur Erzielung einer klammerförmigen Halterung für ein Halbleiterelement über dem entsprechenden ersten Kontaktelement (2, 1) fest angebracht sind.

10. Vorrichtung nach Anspruch 8, dadurch gekennzeichnet, daß der Fortsatz (5c) und die bandförmige Kontaktfahne (2a - 2b) jeweils als Stromleiterteile zwischen einem ersten Anschlußelement (4) und dem mittleren Anschlußelement (5) verlaufend angeordnet sind und auf jedem Stromleiterteil der hülsenförmige Schenkel (13a) eines gesonderten Kontaktschuhs aufgesteckt und der andere, abgewinkelt verlaufende Schenkel als jeweiliges zweites Kontaktelement (13c) ausgebildet und beweglich gehaltert auf dem zugeordneten ersten Kontaktelement (1, 2) angeordnet ist.

11. Vorrichtung nach einem der Ansprüche 9 oder 10, dadurch gekennzeichnet, daß zusätzlich zu den Kontaktelementen (1, 2; 3, 13c) und zu den Anschlußelementen (4, 5) Kontaktstege (11, 11a) zur Führung von Steuer- und Hilfselektroden der Halbleiterelemente parallel zur und im Abstand über der ersten Ebene, vom Transportsteg (7) aus verlaufend, angeordnet sind.

12. Vorrichtung nach Anspruch 9 oder 10, dadurch gekennzeichnet, daß die zweiten Kontaktelemente (3, 13c) jeweils eine Durchbohrung (6) zum Durchtritt einer Hilfselektrode des Halbleiterelements aufweisen.

13. Vorrichtung nach Anspruch 7 oder einem der folgenden Ansprüche, dadurch gekennzeichnet, daß wenigstens die Anschlußelemente (4, 5) je eine Öffnung (10) zur mechanischen Verankerung in der Isolierstoffgießmasse aufweisen.

14. Vorrichtung nach Anspruch 7 oder einem der folgenden Ansprüche, dadurch gekennzeichnet, daß die zweiten Kontaktelemente (3, 13c) im Anschluß an ihre Verbindungsfläche zum Halbleiterelement einen Dehnungsbogen zur Aufnahme thermisch bedingter mechanischer Spannungen aufweisen.

**Fig. 1**

Fig.2

Fig.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | FR-A-2 503 526 (LE SILICIUM SEMICONDUCTEUR SSC) * Seite 4, Zeile 20 - Seite 7, Zeile 26; Figuren 3-6 * | 1,2,4,6 -8,12 | H 01 L 25/07 |
| Y | | 5,9,13, 14 | |
| A | | 3,10,11 | |
| | --- | | |
| Y | DE-A-2 819 327 (SEMIKRON) * Seite 10, Zeile 11 - Seite 12, Zeile 20; Figuren 1-4 * | 5,9,14 | |
| A | | 1,2,4,6 -8,11 | |
| | --- | | |
| Y | EP-A-0 001 892 (AMP INC.) * Seite 7, Zeilen 4-13; Figur 6 * ----- | 13 | |

RECHERCHIERTE SACHGEBIETE (Int. Cl.5)

H 01 L 23/00
H 01 L 25/00

Der vorliegende Recherchenbericht wurde für alle Patentansprüche erstellt

| Recherchenort | Abschlußdatum der Recherche | Prüfer |
|---|---|---|
| DEN HAAG | 26-02-1990 | ZEISLER P.W. |